# EUROPÄISCHE PATENTSCHRIFT

(11) **EP 0 646 300 B1**
(45) Veröffentlichungstag und Bekanntmachung des Hinweises auf die Patenterteilung: **03.01.1996**
(21) Anmeldenummer: 93912925.0
(22) Anmeldetag: 09.06.1993
(51) Int. Cl.: H04B 1/66

(54) **VERFAHREN FÜR DIE FEHLERERKENNUNG DIGITALISIERTER, DATENREDUZIERTER TON- UND DATENSIGNALE**
METHOD OF DETECTING ERRORS IN DIGITIZED DATA-REDUCED AUDIO AND DATA SIGNALS
PROCEDE DE DETECTION DES ERREURS DANS DES SIGNAUX SONORES ET DES SIGNAUX DE DONNEES NUMERISES AVEC REDUCTION DE DONNEES

(30) Priorität: 13.06.1992 DE 4219400
(43) Veröffentlichungstag der Anmeldung: 05.04.1995
(73) Patentinhaber: Institut für Rundfunktechnik GmbH, D-80939 München (DE)
(72) Erfinder: SEDLMEYER, Robert, D-8045 Ismaning (DE); WIESE, Detlef, D-85399 Hallbergmoos (DE)
(74) Vertreter: Konle, Tilmar
(86) Internationale Anmeldenummer: EP9301454
(87) Internationale Veröffentlichungsnummer: WO9326099

(56) Entgegenhaltungen:
- EP-A- 0 220 781
- EP-A- 0 402 973
- DE-A- 2 330 152
- DE-A- 3 638 922
- DE-A- 4 202 654
- EBU REVIEW- TECHNICAL. Nr. 246, April 1991, BRUSSELS BE Seiten 87 - 112 G. PLENGE 'DAB - A new sound broadcasting system Status of the development - Routes to its introduction'
- ICASSP 89 - INTERNATIONAL CONFERENCE ON ACOUSTICS, SPEECH, AND SIGNAL PROCESSING GLASGOW, GB Seiten 2021 - 2024 'Transform coding of audio signals using correlation between successive transform blocks'

## Beschreibung

Die Erfindung bezieht sich auf ein Verfahren gemäß dem Oberbegriff der nebengeordneten Patentansprüche 1 bis 4.

Aus der Zeitschrift "EBU Review-Technical, Nr. 246, April 1991, Seiten 87-112 ist es bekannt, digitalisierte, datenreduzierte Tonsignale oder Datensignale über Rundfunkkanäle zu übertragen. Ein Verfahren zur Datenreduktion von digitalisierten Tonsignalen ist aus der EP-A-0 402 973 bekannt. In dieser Druckschrift ist auch die Mögichkeit erwähnt, die digitalisierten, datenreduzierten Tonsignale auf einem Speichermedium aufzuzeichnen. Um bei der bekannten Rundfunkübertragung auch einen Empfang unter schlechten Übertragungsbedingungen, beispielweise durch Abschattungen bei mobilem Empfang, zu gewährleisten, wird dem digitalisierten, datenreduzierten Tonsignal ein relativ hoher Bitfehlerschutz sendeseitig hinzugefügt. Bei einer Überlastung des Bitfehlerschutzes durch eine zu hohe Bitfehlerrate können die auftretenden Fehler nicht mehr korrigiert werden, was im rekonstruierten Tonsignal zu starken Klangverfälschungen führen kann. In einem solchen Fall muß das Tonsignal für die Dauer der Störung stummgeschaltet werden. Besser ist es, eine geeignete Maßnahme zur Fehlerverschleierung zu treffen. Solche Fehlerverschleierungsmaßnahmen sind beispielsweise aus der DE-A-4 111 131 vom 08.10.1992 bekannt, wonach bei der gestörten Übertragung von datenreduzierten, digitalisierten Tonsignalen verschiedene Möglichkeiten zur Anwendung von Fehlerverschleierungstechniken herangezogen werden können, derart, daß gestörte Teilbänder oder Spektralwerte stummgeschaltet, abgeschätzt oder durch vorangegangene bzw. die des Komplementärkanals eines stereofonen Signals ersetzt werden können und dadurch die subjektive Störwirkung herabgesetzt wird. Voraussetzung für eine solche Fehlerverschleierung ist die Erkennung und genaue Lokalisation von Übertragungsfehlern. Dazu bedarf es der zusätzlichen Übertragung oder Speicherung von Fehlererkennungscodes zur Bestimmung der als fehlerhaft anzusehenden Signalanteile. Dies bedeutet eine Erhöhung der zu übertragenden oder zu speichernden Datenmenge und somit eine Verringerung der angestrebten Frequenzökonomie.

Die Aufgabe der Erfindung besteht darin, ein Verfahren der eingangs erwähnten Art dahingehend zu verbessern, daß eine zusätzliche Übertragung oder Speicherung von Fehlererkennungscodes für die Informationseinheiten und somit eine höhere Datenrate weitgehend vermieden werden kann.

Diese Aufgabe wird erfindungsgemäß durch die kennzeichnenden Merkmale der nebengeordneten Patentansprüche 1 bis 4 gelöst.

Vorteilhafte Weiterbildungen des erfindungsgemäßen Verfahrens ergeben sich aus den Unteransprüchen.

Ein Ausführungsbeispiel des erfindungsgemäßen Verfahrens wird anhand der Zeichnungen näher erläutert. Es zeigt:
- Figur 1: ein Blockschaltbild einer Rundfunkstrecke, bestehend aus Sende- und Empfangsanlage,
- Figur 2: schematische Darstellungen aufeinanderfolgender, bei dem erfindungsgemäßen Verfahren benutzter Informationsblöcke,
- Figur 3: schematisch einen Informationsblock, dem eine von einem Fehlerschutzcode abgeleitete Zuverlässigkeitsinformation zugeordnet ist,
- Figur 4: ein radiofrequentes Signal, das in einzelne Informationsteile zerteilt und auf unterschiedlichen spektralen Trägerfrequenzen übertragen wird,
- Figur 5: ein radiofrequentes Signal, dessen einzelne Informationsteile auf unterschiedlichen spektralen Trägerfrequenzen durch Mehrwegeausbreitung unterschiedlich stark bedämpft werden.

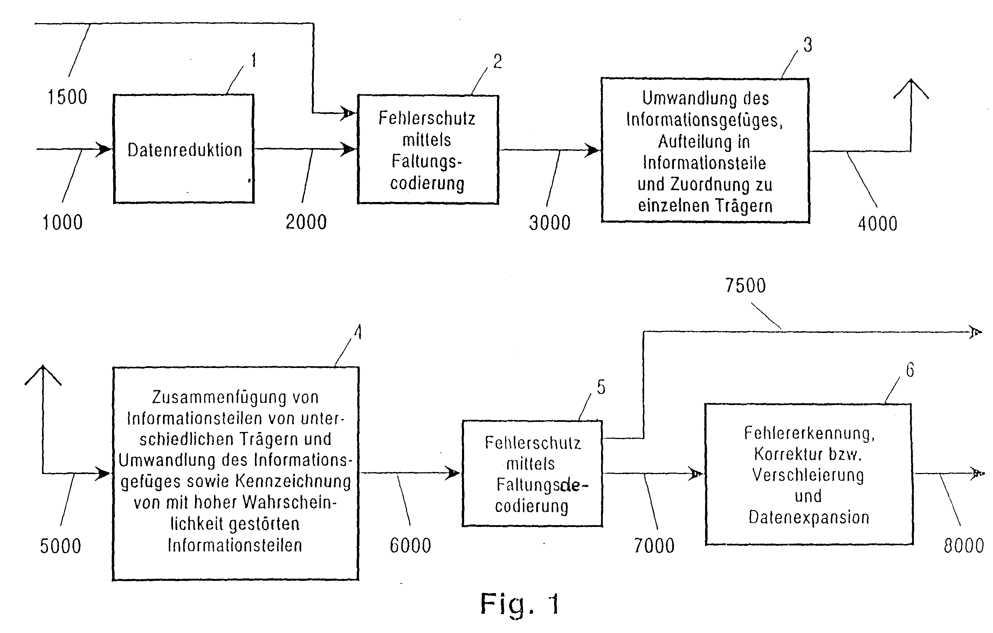

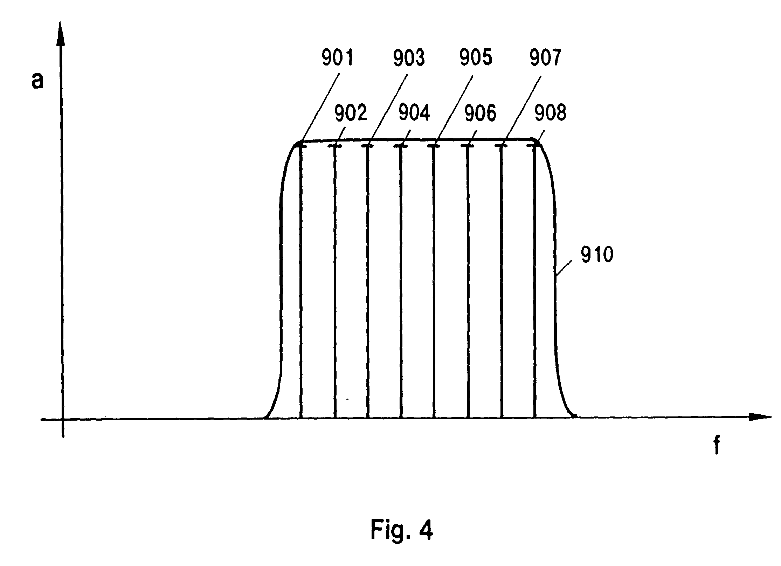

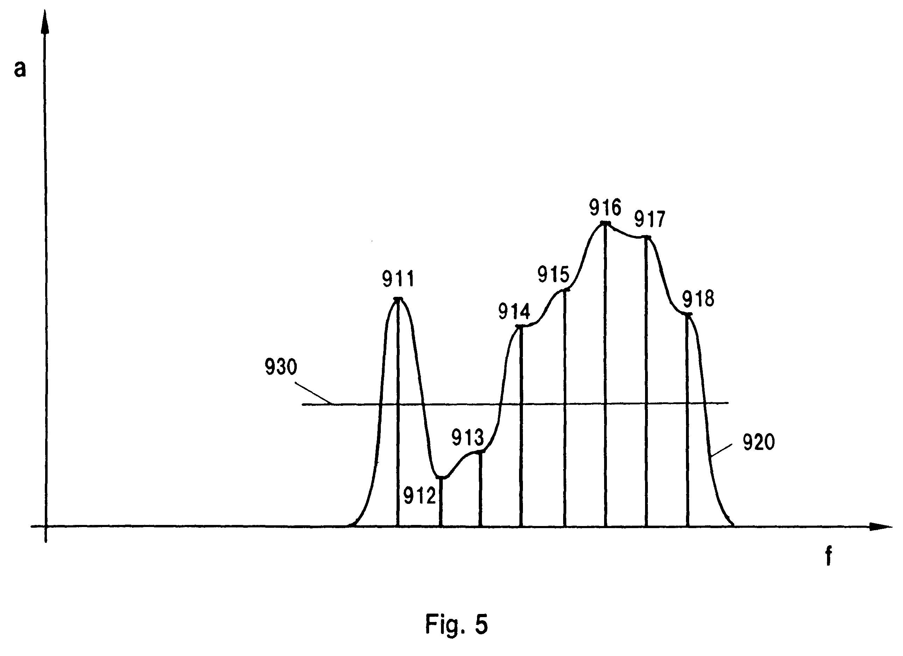

Figur 1 zeigt anhand eines Blockschaltbildes eine Rundfunkstrecke, bestehend aus Sender und Empfänger. Das zu übertragende digitalisierte Tonsignal 1000, welches aus aufeinanderfolgenden, später noch genauer zu beschreibenden Informationsblöcken besteht, wird in einer Stufe 1 einer Datenreduktion unterzogen. Das datenreduzierte Tonsignal 2000 wird einer Stufe 2 zur Anwendung eines Fehlerschutzes zugeführt. Zusätzlich kann dieser Stufe 2 auch gegebenenfalls ein Datensignal 1500 zugeführt werden. Bei dem in der Stufe 2 zur Anwendung kommenden Fehlerschutz handelt es sich beispielsweise um eine Faltungscodierung. Das fehlergeschützte Signal 3000 am Ausgang der Stufe 2 wird in der Stufe 3 hinsichtlich seines Informationsgefüges in eine geeignete Form zur Übertragung über den gestörten Rundfunkkanal umgewandelt, beispielsweise durch einen zeitlichen Interleaving-Prozeß. Ferner beinhaltet die Umwandlung des Informationsgefüges eine Transformation in den Spektralbereich, wodurch das gesamte Informationsgefüge in einzelne Informationsteile aufgeteilt wird, welche RF-mäßig unterschiedlichen Trägern zugeordnet werden. In Fig. 4 ist schematisch der Aufbau des RF-Signals 4000 dargestellt. Das ausgesendete RF-Signal 4000 besteht aus mehreren benachbarten Trägern, hier beispielsweise die acht Träger 901-908 mit unterschiedlichen Frequenzen, auf die die einzelnen Informationsteile des Informationsgefüges aufgeteilt sind. Wie in Fig. 5 schematisch dargestellt, erfährt ein solches ausgesendetes Signal bei der Übertragung durch Mehrwegeausbreitung eine Verzerrung der einzelnen Träger 911-918, die durch die gegenüber der Hüllkurve 910 in Fig. 4 veränderte Hüllkurve 920 in Fig. 5 verdeutlicht wird. Diese Verzerrung verursacht eine unterschiedliche Dämpfung und Phasendrehung der einzelnen Träger.

Das empfangene Signal 5000 wird im Empfänger in der Stufe 4 hinsichtlich seines Informationsgefüges derart umgewandelt, daß die einzelnen Informationsteile, die den unterschiedlichen Trägern zugeordnet waren, wieder zusammengefügt werden, was beispielsweise mittels einer Transformation, sowie eines zur Sendeseite inversen Interleavingprozesses geschehen kann. Das Ausgangssignal 6000 der Stufe 4 wird der Stufe 5 zur Anwendung einer Fehlerschutzdecodierung zugeführt, die beispielsweise unter Verwendung einer Faltungsdecodierung das Signal 6000 in ein datenreduziertes Tonsignal 7000 und gegebenenfalls in ein Datensignal 7500 verwandelt.

In den Stufen 4 und 5 wird dabei folgender Umstand berücksichtigt: In dem Maße, wie die einzelnen Träger, denen bei der Übertragung Informationsteile zugeordnet waren, durch Mehrwegeausbreitung in ihrem Pegel gedämpft und deshalb durch Rauschen oder Störsignale verfälscht werden, steigt die Wahrscheinlichkeit, daß die ihnen zugewiesenen, und durch sie übertragenen Informationsteile fehlerbehaftet empfangen wurden. Deshalb werden diese fehlerbehafteten Bits des Signales 6000 durch Anwendung einer Faltungsdecodierung ermittelt und korrigiert. Dies ist jedoch nur bis zu einer gewissen Anzahl von Fehlern möglich, und die Fehlerkorrektur ist in ihrer Wirkung von der vorliegenden Fehlerstruktur abhängig.

Das datenreduzierte Tonsignal 7000 wird in der Stufe 6 einer Fehlererkennung, Fehlerkorrektur bzw. Fehlerverschleierung unterworfen, welche nicht nur nach bekannten Verfahren vorgeht, sondern die im weiteren genauer beschriebenen erfindungsgemäßen Vorgehensweisen beinhaltet.

Durch Anwendung eines weiteren, erfindungsgemäüßen Prozesses innerhalb der Stufe 4 kann jedoch die Effektivität sowohl des Fehlerschutzes mittels eines Faltungsdecodierers in der Stufe 5, als auch die Effektivität der Fehlererkennung, Fehlerkorrektur bzw. Fehlerverschleierung in der Stufe 6 erheblich gesteigert werden: Werden ein oder mehrere Träger, denen bei der Übertragung Informationsteile zugeordnet waren, durch Mehrwegeausbreitung in ihrem Pegel stark vermindert und deshalb durch Rauschen oder Störsignale verfälscht, wodurch mit hoher Wahrscheinlichkeit zu erwarten ist, daß die ihm oder ihnen zugewiesenen, und durch ihn oder sie übertragenen Informationsteile fehlerbehaftet empfangen wurden, und ist dieses innerhalb der Stufe 4 des Empfängers bekannt, so kann diese Information zur Fehlererkennung, Fehlerkorrektur und Fehlerverschleierung verwendet werden.

Wenn ein oder mehrere Träger in ihrem Pegel stark vermindert empfangen werden, und dieser Pegel wie in Fig. 5 dargestellt eine Schwelle 930 unterschreitet, die je nach Empfangssituation und Interferenzbedingung unterschiedlich positioniert werden kann, so können die durch den oder die Träger übertragenen Informationsteile - eventuell auch einzelne Bits - als fehlerbehaftet gekennzeichnet, und damit ein entsprechendes Wissen an die nachfolgenden Stufen weitergegeben werden.

Ist innerhalb der Stufe 5 in Fig. 1 ein solches Wissen über gestörte Informationsteile bekannt, so kann ein geeigneter Faltungsdecodierer zur Rekonstruktion des Ausgangssignales gezielt nur diejenigen Informationsteile benutzen, die mit hoher Wahrscheinlichkeit nicht gestört sind, und wird in seinen Entscheidungen nicht durch Informationsteile gestört, die ohnehin mit hoher Wahrscheinlichkeit als gestört eingeordnet werden können.

Ist innerhalb der Stufe 6 in Fig. 1 ein solches Wissen über gestörte Informationsteile bekannt, so kann ein Verfahren zur Fehlererkennung, Fehlerkorrektur und Fehlerverschleierung umso effizienter arbeiten, desto genauer und sicherer einzelne fehlerhafte Informationsteile, Informationseinheiten oder Bitmuster identifiziert werden.

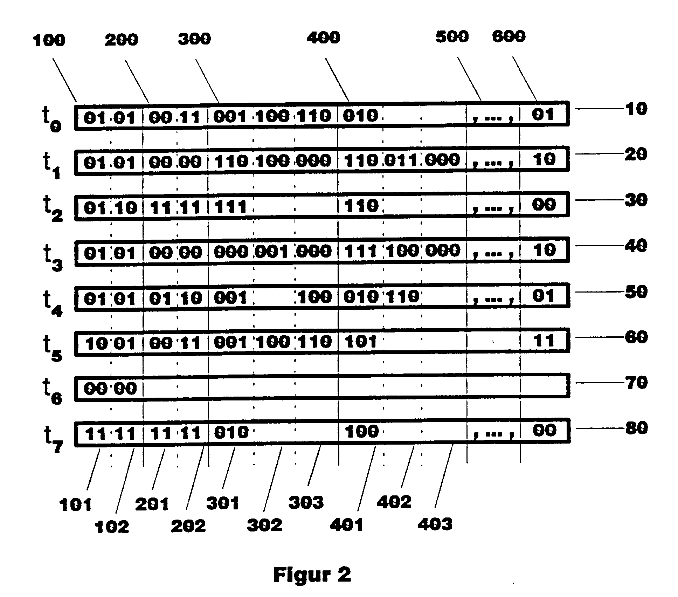

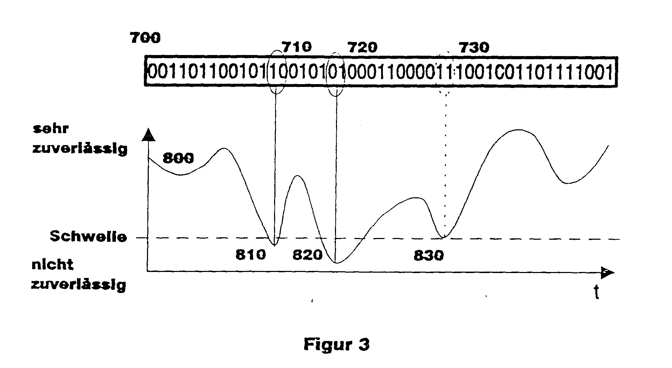

Das Ausführungsbeispiel zur Darstellung weiterer erfindungsgemäßer Verfahrensschritte in Figur 2 und 3 geht von folgenden Systemvoraussetzungen aus:
- es handelt sich um ein monophones datenreduziertes Tonsignal, welches aus aufeinanderfolgenden Informationsblöcken besteht,
- es handelt sich um eine Teilbandcodierung in zwei Teilbänder,
- ein Informationsblock besteht aus fünf Informationseinheiten, nämlich einer Bitzuweisungsinformationseinheit, einer Skalenfaktorselektierungsinformationseinheit, einer Skalenfaktorinformationseinheit, einer Teilbandabtastwerteinformationseinheit, sowie einer Vektorinformationseinheit,
- ein Informationsblock hat die Dauer t,
- innerhalb eines Informationsblockes werden encoderseitig aus einer bestimmten Anzahl aufeinanderfolgender Teilbandabtastwerte für jedes der beiden Teilbänder drei Skalenfaktoren scf1, scf2, scf3, die ein Maß für den Pegel in dem entsprechenden Teilband sind, für eine jeweilige Dauer von t/3 gebildet, jedoch nur bei großen Unterschieden zwischen den Skalenfaktoren, alle drei Skalenfaktoren übertragen,
- es gibt drei verschiedene Bitzuweisungsbitmuster mit folgendem Inhalt:
   - 00: keine Übertragung der zu einem Teilband gehörenden Informationen
   - 01: die Teilbandabtastwerte werden mit 2 Bit quantisiert
   - 10: die Teilbandabtastwerte werden mit 3 Bit quantisiert
- es gibt vier verschiedene Skalenfaktorselektierungsbitmuster mit folgendem Inhalt:
   - 00: drei Skalenfaktoren werden übertragen, da sie sich stark unterscheiden
   - 01: zwei Skalenfaktoren werden übertragen, wobei der erste Skalenfaktor für scf1, der zweite für scf2 und scf3 einzusetzen ist, da scf1 und scf2 sich stark unterscheiden
   - 10: zwei Skalenfaktoren werden übertragen, wobei der erste Skalenfaktor für scf1 und scf2, der zweite für scf3 einzusetzen ist, da scf2 und scf3 sich stark unterscheiden
   - 11: ein Skalenfaktor wird übertragen, wobei dieser Skalenfaktor für scf1, scf2 und scf3 einzusetzen ist, da die ursprünglichen Skalenfaktoren scf1, scf2 und scf3 sich kaum unterscheiden
- es gibt 8 verschiedene Skalenfaktorklassen, die jeweils mit 3 Bit dargestellt werden,
   - 000: geringer Pegel der Teilbandabtastwerte
   - 001: .
   - 010: .
   - 011: .
   - 100: .
   - 101: .
   - 110: .
   - 111: hoher Pegel der Teilbandabtastwerte,
- die Teilbandabtastwerte werden entweder mit zwei, drei Bit oder gar nicht dargestellt,
- es gibt für die Dauer t/3 vier Teilbandabtastwerte,
- es gibt drei verschiedene Vektorbitmuster mit folgendem Inhalt
   - 00: keine Pegeländerung
   - 01: starker Pegelanstieg
   - 10: starker Pegelabfall.

Die Figur 2 zeigt schematisch acht aufeinanderfolgende Informationsblöcke eines zu übertragenden oder zu speichernden Tonsignals. Jeder der acht aufeinanderfolgenden Informationsblöcke 10, 20, 30, 40, 50, 60, 70, 80 zu den Zeitpunkten t0 bis t7 ist in fünf Informationseinheiten aufgeteilt:
- Bitzuweisungsinformation 100, die aus zwei Bitmustern besteht, nämlich 101 für das erste Teilband und 102 für das zweite Teilband;
- Skalenfaktorselektierungsinformation 200, die aus zwei Bitmustern besteht, nämlich 201 für das erste Teilband und 202 für das zweite Teilband;
- Skalenfaktoren 300 für das erste Teilband und 400 für das zweite Teilband, wobei die Anzahl der übertragenen bzw. gespeicherten Skalenfaktoren nach Maßgabe der Skalenfaktorselektierungsinformation variiert und die Skalenfaktoren für jedes Teilband drei Positionen 301, 302, 303 bzw. 401, 402, 403 belegen können;
- Teilbandabtastwerte 500, die nicht genau dargestellt sind;
- Vektorinformationseinheit 600 mit Informationen über den Pegelverlauf des datenreduzierten Tonsignals.

Die Bitzuweisungsinformation 100 des Informationsblockes 10 zum Zeitpunkt t0 gibt durch die beiden Bitmuster 101 und 102 mit dem Inhalt '01' und '01' an, daß die Teilbandabtastwerte der beiden Teilbänder mit jeweils 2 Bit quantisiert übertragen bzw. gespeichert werden. Die Skalenfaktorselektierungsinformation 200 des gleichen Informationsblockes gibt mit dem ersten Bitmuster '00' für das erste Teilband an, daß drei Skalenfaktoren übertragen werden und somit ein starker Pegelanstieg oder -abfall vorliegt. Dies wird durch die Skalenfaktoren 300 des ersten Teilbandes '001', '100' und '110', die einen starken Pegelanstieg aufweisen, bestätigt. Mit dem zweiten Bitmuster '11' für das zweite Teilband wird angezeigt, daß ein Skalenfaktor übertragen wird. Dieser Skalenfaktor 400 des zweiten Teilbandes '010' gilt für die gesamte Zeit t des Informationsblockes t0 und deutet auf einen gleichbleibenden Pegel hin. Die Teilbandabtastwerte 500 sind für alle Informationsblöcke 10 bis 80 zu den Zeiten t0 bis t7 nicht detailliert dargestellt, da dies für die Erläuterung der beispielhaften Ausführung des erfindungsgemäßen Verfahrens nicht von Bedeutung ist. Die Vektorinformationseinheit 600 gibt mit dem Bitmuster '01' an, daß ein starker Pegelanstieg des Tonsignals vorliegt. Bei Vergleich dieser Information mit der Skalenfaktorselektierungsinformation des ersten Teilbandes, die aufgrund der Indikation, drei Skalenfaktoren zu übertragen, auf eine große Änderung hindeutet und mit den in diesem Teilband übertragenen Skalenfaktoren, die einen starken Pegelanstieg vollziehen, stellen sich die betrachteten Informationseinheiten als plausibel dar, deuten also nicht auf einen Fehler.

Zum Zeitpunkt t1 wird im Informationsblock 20 durch die beiden Skalenfaktorselektierungsbitmuster '00' und '00' für beide Teilbänder indiziert, daß jeweils drei Skalenfaktoren übertragen werden. Die beiden Folgen von drei Skalenfaktoren '110', '100', '000' bzw. '110', '011', '000' deuten auf einen starken Pegelabfall in beiden Teilbändern. Ein Vergleich mit der Vektorinformationseinheit 600 desselben Informationsblockes 20 ergibt, daß die empfangenen Daten als zuverlässig angesehen werden können, da das Vektorbitmuster '10' einen starken Pegelabfall des Tonsignals anzeigt.

Zum Zeitpunkt t2 indiziert die Skalenfaktorselektierungsinformation des Informationsblockes 30 für beide Teilbänder nur einen Skalenfaktor zu übertragen, nämlich im ersten Teilband den höchsten '111', im zweiten Teilband den Skalenfaktor '110'. Falls die Häufigkeitsverteilung der Skalenfaktorwerte für das erste Teilband zeigt, daß der höchste Skalenfaktorwert '111' äußerst selten vorkommt, müßte dieser Skalenfaktor als fehlerhaft deklariert werden. Genauso würde man verfahren, falls die zeitliche Folge der Skalenfaktorwerte im ersten Teilband '000', '111', '000' ('000' letzter Skalenfaktor des Informationsblocks 20, '111' Skalenfaktor des Informationsblocks 30, '000' erster Skalenfaktor des Informationsblocks 40) als äußerst selten vorkommend eingestuft werden müßte. Im folgenden Informationsblock 40 zum Zeitpunkt t3 werden für jedes Teilband drei Skalenfaktoren übertragen. Die Skalenfaktorfolge '000', '001','000' für das erste Teilband muß als fehlerhaft deklariert werden, da die durch die Skalenfaktorselektierungsinformation indizierte Übertragung von drei Skalenfaktoren auf eine große Änderung zwischen den aufeinanderfolgenden Skalenfaktoren hinweist, diese sich jedoch nur um eine Klasse unterscheiden. Die Folge des zweiten Teilbandes '111', '100', '000' kann als zuverlässig angesehen werden, da es sich zum einen um große Änderungen handelt, zum anderen dieser Pegelabfall mit dem durch das Vektorinformationsbitmuster '10' angezeigten Pegelabfall übereinstimmt. Eine Annäherung der als fehlerhaft anzusehenden Skalenfaktoren des ersten Teilbandes an die wahrscheinlich ursprünglich übertragenen Skalenfaktoren kann z.B. durch Interpolation zwischen dem Skalenfaktor des ersten Teilbandes des Informationsblockes 30 zum Zeitpunkt t2, d.h. '111' und dem letzten der drei Skalenfaktoren des Informationsblockes 40 zum Zeitunkt t3 erreicht werden, da dieser letzte Skalenfaktor aufgrund der durch das Vektorbitmuster '10' angedeutete Pegelabfall durchaus mit einem '000' Skalenfaktor enden kann. Die Folge der korrigierten bzw. fehlerverschleierten Skalenfaktoren des ersten Teilbandes des Informationsblockes 40 lautet dann '101', '011', '000'.

Zum Zeitpunkt t5 werden im ersten Teilband des Informationsblockes 60 drei Skalenfaktoren übertragen, deren Inhalt '001', '100', '111' auf einen starken Pegelanstieg deuten. Da das für diesen Block dargestellte Vektorbitmuster '11' überhaupt nicht im Codevorrat enthalten ist, kann es ersetzt werden durch das Bitmuster '01' und somit korrigiert werden.

Um die Möglichkeiten der decoderseitigen Fehlererkennung noch zu erweitern, werden zusätzlich ein oder mehrere Codes encoderseitig für eine Fehlererkennung innerhalb einer oder mehrerer Informationseinheiten generiert und in die aufeinanderfolgenden zu übertragenden oder zu speichernden Informationsblöcke in Form ein oder mehrerer zusätzlicher Informationseinheiten eingefügt, wobei eine beliebige aber feste Anzahl an Fehlern erkannt, der Fehlerort jedoch nicht genau lokalisiert werden kann. Dies kann beispielsweise mit der Einfügung von 'parity bits' oder sogenannten CRCs (Cyclic Redundancy Codes) erfolgen. Nachdem für einen Informationsblock die Anzahl der möglichen Fehler aufgrund von Plausibilitätsüberprüfungen bestimmt worden ist, sollte - sofern vorhanden - ein Vergleich mit der aufgrund des Fehlererkennungscodes bestimmten Fehleranzahl erfolgen. Ist die durch unterschiedliche Methoden hergeleitete Fehleranzahl identisch, so kann dies als Bestätigung gewertet werden. Falls die durch den Fehlererkennungscode bestimmte Fehleranzahl kleiner ist als die aufgrund der von Plausibilitätsüberprüfungen abgeleitete, so sollten entweder die aufgrund von Plausibilitätsüberprüfungen mit den geringsten Wahrscheinlichkeiten oder die aufgrund der leistungsfähigeren Methode (Plausibilität oder Fehlererkennungscode) als fehlerhaft deklariert werden. Sollte der Fehlererkennungscode sehr leistungsfähig und die durch ihn bestimmte Fehleranzahl größer sein als die aufgrund von Plausibilitätsüberprüfungen abgeleitete, so ist anzunehmen, daß der Plausibilitätsüberprüfung Fehler entgangen sind.

Figur 3 zeigt einen Informationsblock 700 und eine diesem Block zeitlich zugeordnete Zuverlässigkeitsinformation 800, die von einem Fehlerschutzcode empfangsseitig abgeleitet wird. Die Bitmuster des Informationsblockes 700 sind hier nicht den einzelnen Informationseinheiten zugeordnet, da dies für die Erläuterung nicht von Bedeutung ist. Je nach Art der Übertragungsstörungen wechselt die Zuverlässigkeitsinformation mehr oder weniger ihren Zustand zwischen 'empfangenes Bit, bzw. Bitmuster nicht zuverlässig' und 'empfangenes Bit, bzw. Bitmuster sehr zuverlässig'. Die eingezeichnete Schwelle 900 gibt ein Maß für die Zuordnung hinsichtlich der Zuverlässigkeit an. Die lokalen Minima 810 und 820 liegen unterhalb der eingezeichneten Schwelle 900, was dazu führt, daß die diesen lokalen Minima zugeordneten empfangenen Bits, bzw. Bitmuster 710 und 720 als nicht zuverlässig klassiert werden. Sollte ein zusätzlich eingefügter Fehlererkennungscode beispielsweise 3 Fehler innerhalb des Informationsblockes 700 indizieren, so wird zur Lokalisation des Fehlers das nächste hinsichtlich der Zuverlässigkeit auf nächsthöherem Niveau liegende lokale Minimum 830 herangezogen, selbst wenn es über der eingezeichneten Schwelle 900 liegt. Das diesem lokalen Minimum 830 zugeordnete Bit, bzw. Bitmuster 730 wird als fehlerhaft deklariert.

Es versteht sich, daß die Zuverlässigkeitsinformation mit einer bestimmten Auflösung, z.B. 3 bit digitalisiert vorliegen kann. Die für das erfindungsgemäße Verfahren verwendeten Informationsblöcke können derart aufgebaut sein, daß alle oder ein Teil der verwendeten Informationseinheiten von variierender Länge sind, was dazu führt, daß eine vollständige Decodierung eines Informationsblockes nur dann erfolgen kann, wenn alle oder ein Teil aller Informationseinheiten sukzessive richtig decodiert werden können. Dabei sollten die Plausibilitätsüberprüfungen optimalerweise am Anfang eines Informationsblockes beginnen, da bei einem als fehlerhaft deklarierten und nicht mehr korrigierbaren und fehlerverschleierbaren Bitmuster davon ausgegangen werden kann, daß alle nachfolgenden Bitmuster nicht mehr richtig decodiert werden können.

Bei der Übertragung über stark störbehaftete Kanäle ist die Höhe der Restbitfehlerrate für die einzelnen Informationseinheiten des Informationsblockes abhängig von dem angewendeten Bitfehlerschutz. Ein Fehler in einem sehr hoch geschützten Bitmuster kann zu der Annahme führen, daß alle weniger geschützten Bitmuster auf jeden Fall auch gestört, wahrscheinlich sogar stärker gestört sind.

Die aufgrund von Plausibilitätsuntersuchungen angestellten - durch Fig. 2 gezeigten - Fehlererkennungen führen zu Möglichkeiten der Fehlerkorrektur bzw. -verschleierung. Dies kann beispielsweise eine Interpolation sein, jedoch auch die unter Verwendung eines auf statistischen Kenntnissen basierenden Prädiktionsmodells vorhergesagten und bei Fehlern von den tatsächlich decodierten Werten abweichenden Werte. Beispielsweise ist die spektrale Energieverteilung von Audiosignalen derart gestaltet, daß die Energie von tiefen zu hohen Frequenzen hin abnimmt. Weicht nun die Energieverteilung ab, indem beispielsweise ein Teil des oberen Audiospektralbereiches eine sehr hohe Energie aufweist, so kann dies bei Vergleich mit einem durch das Prädiktionsmodell vorhergesagten Wert zu einer Fehlerdeklaration führen.

Für den Fall, daß Fehler in einem oder mehreren Informationsblöcken deklariert werden, durch die der vollständige Informationsblock nicht mehr decodiert werden kann, weil beispielsweise die den Aufbau des Informationsblockes bitgenau beschreibende Bitzuweisung gestört ist, besteht die Notwendigkeit, eine blockbezogene Fehlerverschleierung anzuwenden, um die Stummschaltung eines oder mehrerer vollständiger Informationsblöcke zu vermeiden. Solche durch Stummschaltung erzeugten Signalausfälle können beim mobilen Empfang von Hörrundfunksignalen mehrere 100 ms dauern. Falls ein Hörrundfunkprogrammsignal sendeseitig gleichzeitig oder auch zeitlich verzögert mehr als einmal unter Verwendung derselben oder verschiedener Übertragungssysteme übertragen wird und empfangsseitig ein Empfänger verwendet wird, der mindestens zwei der übertragenen Tonsignale gleichen Programminhalts empfangen und verarbeiten kann, so wird für den Zeitraum der Störung das Signal des anderen Übertragungssystems herangezogen, um es anstelle des gestörten einzusetzen. Da zwischen diesen beiden Tonsignalen gleichen Programminhaltes Pegel- oder Zeitversatzunterschiede auftreten können, die ggf. kompensiert werden oder auch die Zahl der zu dem Programm gehörenden Tonkanäle verschieden sein kann, ist unter Umständen ein Qualitätsverlust durch diesen Signalersatz gegeben. Verglichen mit der ansonsten nur zur Verfügung stehenden Stummschaltung handelt es sich um eine Fehlerverschleierung, die keinen Informationsverlust bedeuten muß.

## Patentansprüche

1. Verfahren für die Fehlererkennung eines aus einer Folge von Informationsblöcken (10-80) bestehenden digitalisierten, datenreduzierten Tonsignals (7000), wobei die einzelnen Informationsblöcke (10-80) aus Informationseinheiten (100-600), wie z. B. Bitzuweisungsinformation (100), Skalenfaktorselektierungsinformation (200), Skalenfaktoren (300,400), encodierten Abtastwerten (500) des digitalisierten, einer Teilbandfilterung oder einer Transformation in den Spektralbereich unterzogenen Tonsignals (1000) sowie Zusatzinformation (600) bestehen, **dadurch gekennzeichnet**, daß ein oder mehrere, den Informationseinheiten (100-600) eines Informationsblockes (10-80) zuzuordnende Bitmuster (101,102,201,202,301,302,303,401,402,403) hinsichtlich der Wahrscheinlichkeit ihres Auftretens eingestuft und bei Unterschreitung einer unteren Wahrscheinlichkeitsschwelle als fehlerhaft deklariert werden.

2. Verfahren für die Fehlererkennung eines aus einer Folge von Informationsblöcken (10-80) bestehenden digitalisierten, datenreduzierten Tonsignals (7000), wobei die einzelnen Informationsblöcke (10-80) aus Informationseinheiten (100-600), wie z. B. Bitzuweisungsinformation (100), Skalenfaktorselektierungsinformation (200), Skalenfaktoren (300,400), encodierten Abtastwerten (500) des digitalisierten, einer Teilbandfilterung oder einer Transformation in den Spektralbereich unterzogenen Tonsignals (1000) sowie Zusatzinformation (600) bestehen, **dadurch gekennzeichnet**, daß zwei oder mehrere, den Informationseinheiten (100-600) eines Informationsblockes (10-80) zuzuordnende Bitmuster (101,102,201,203,301,302,303,401,402,403) hinsichtlich der Wahrscheinlichkeit ihres im wesentlichen zeitgleichen Auftretens eingestuft und bei Unterschreitung einer unteren Wahrscheinlichkeitsschwelle als fehlerhaft deklariert werden.

3. Verfahren für die Fehlererkennung eines aus einer Folge von Informationsblöcken (10-80) bestehenden digitalisierten, datenreduzierten Tonsignals (7000), wobei die einzelnen Informationsblöcke (10-80) aus Informationseinheiten (100-600), wie z. B. Bitzuweisungsinformation (100), Skalenfaktorselektierungsinformation (200), Skalenfaktoren (300,400), encodierten Abtastwerten (500) des digitalisierten, einer Teilbandfilterung oder einer Transformation in den Spektralbereich unterzogenen Tonsignals (1000) sowie Zusatzinformation (600) bestehen, **dadurch gekennzeichnet**, daß ein oder mehrere, den Informationseinheiten (100-600) eines Informationsblockes (10-80) zuzuordnende Bitmuster (101,102,201,202,301,302,303,401,402,403) hinsichtlich der Wahrscheinlichkeit ihres Auftretens in Abhängigkeit zeitlich vorangegangener und/oder zeitlich nachfolgender Bitmusterderselben oder einer anderen Informationseinheit (100-600) eingestuft und bei Unterschreitung einer unteren Wahrscheinlichkeitsschwelle als fehlerhaft deklariert werden.

4. Verfahren für die Fehlererkennung eines aus einer Folge von Informationsblöcken (10-80) bestehenden digitalisierten, datenreduzierten Tonsignals (7000), wobei die einzelnen Informationsblöcke (10-80) aus Informationseinheiten (100-600), wie z. B. Bitzuweisungsinformation (100), Skalenfaktorselektierungsinformation (200), Skalenfaktoren (300,400), encodierten Abtastwerten (500) des digitalisierten, einer Teilbandfilterung oder einer Transformation in den Spektralbereich unterzogenen Tonsignals (1000) sowie Zusatzinformation (600) bestehen, **dadurch gekennzeichnet**, daß bei Informationsblöcken (10-80), die sendeseitig faltungsencodiert (2), in ein neues Informationsgefüge umgewandelt (3), in einzelne Informationsteile zerteilt, als radiofrequentes Signal (4000) auf unterschiedlichen spektralen Trägerfrequenzen (901-908) übertragen werden und empfangsseitig aus den einzelnen Informationsteilen wieder zu einem Informationsgefüge zusammengefügt (4) und faltungsdecodiert (5) werden, jene Informationsteile, die auf einzelnen Trägerfrequenzen (901-908) übertragen und mit geringerer Empfangsfeldstärke empfangen werden als andere Informationsteile, auf anderen Trägerfrequenzen hinsichtlich einer höheren Fehlerwahrscheinlichkeit markiert werden.

5. Verfahren nach einem der Ansprüche 1 bis 4, **dadurch gekennzeichnet**, daß zusätzlich eine sich ändernde, von dem zu übertragenden Tonsignal (4000) sendeseitig abgeleitete, Stellgröße und/oder zusätzlich ein auf einen Tabelleneintrag über den Pegelverlauf zeigender Vektor in Form ein oder mehrerer zusätzlicher Informationseinheiten (600) in den Informationsblock (10-80) eingefügt werden, und daß empfangsseitig die Stellgröße und/oder der Vektor zur Wahl einer von der übertragenen Programmdynamik abweichenden Wiedergabedynamik verwendet wird.

6. Verfahren nach Anspruch 5, **dadurch gekennzeichnet**, daß die Stellgröße und/oder der Tabelleneintrag und/oder die Informationseinheiten, die eine Aussagekraft über den Pegelverlauf des empfangenen Tonsignals (5000) beinhalten hinsichtlich der Wahrscheinlichkeit ihres im wesentlichen zeitgleichen Auftretens eingestuft und bei Unterschreitung einer unteren Wahrscheinlichkeitsschwelle als fehlerhaft deklariert werden.

7. Verfahren nach einem der Ansprüche 1 bis 6, **dadurch gekennzeichnet**, daß zusätzlich ein oder mehrere Codes (z.B. CRC) encoderseitig für eine Fehlererkennung innerhalb einer oder mehrerer Informationseinheiten (100-500) generiert und in die aufeinanderfolgenden zu übertragenden oder zu speichernden Informationsblöcke (10-80) in Form ein oder mehrerer zusätzlicher Informationseinheiten (700) eingefügt werden und daß decoderseitig die eingefügten Codes (CRC) für eine Fehlererkennung (6) verwendet werden, wobei eine beliebige aber feste Anzahl von Fehlern erkannt, der Fehlerort jedoch nicht genau lokalisiert werden kann.

8. Verfahren nach Anspruch 7, **dadurch gekennzeichnet**, daß nach der Indikation einer bestimmten Fehleranzahl durch den zusätzlich eingefügten Code (CRC) die für den bzw. die Fehler in Betracht zu ziehenden Bitmuster der Informationseinheiten hinsichtlich der Wahrscheinlichkeit ihres Auftretens eingestuft und eine durch die Fehlerindikation bestimmte Anzahl von Bitmustern mit den geringsten Wahrscheinlichkeiten als fehlerhaft deklariert wird.

9. Verfahren nach einem der Ansprüche 1 bis 8, bei dem coderseitig ein Fehlerschutz (CRC) für die zu übertragenden oder zu speichernden Informationseinheiten (100-600) oder Teilen davon mitübertragen bzw. mitgespeichert wird, und bei dem decoderseitig eine Information (800) über die Zuverlässigkeit der zu decodierenden Bitmuster aus dem Fehlerschutz abgeleitet wird, **gekennzeichnet durch** folgende Verfahrensschritte:
a) Eine Schwelle (900) wird bestimmt, unterhalb welcher die den Zuverlässigkeitsinformationen (800) zuzuordnenden Bitmuster (710,720) als unzuverlässig deklariert werden und
b) die einem lokalen Minimum (830) einer Folge von Zuverlässigkeitsinformationen (800) zuzuordnenden Bitmuster (730) werden als fehlerhaft deklariert.

10. Verfahren nach den Ansprüchen 8 und 9, **dadurch gekennzeichnet**, daß die Anzahl der zu bestimmenden lokalen Minima (810,820) mit der durch die zusätzlich eingefügten Fehlererkennungscodes (CRC) indizierten Fehleranzahl übereinstimmt.

11. Verfahren nach einem der Ansprüche 1 bis 10, **dadurch gekennzeichnet**, daß das oder die als fehlerhaft deklarierten Bitmuster (730) von Informationseinheiten (100-700) oder die als fehlerwahrscheinlich markierten Informationsteile auf ihrem weiteren Verarbeitungsweg verfolgt werden, und daß das Wissen über die Fehlerhaftigkeit bzw. Fehlerwahrscheinlichkeit auch bei einer Umwandlung der betreffenden Informationseinheiten (100-700) bzw. Informationsteile in ein anderes Informationsgefüge zur späteren Anwendung eines Fehlerkorrektur- oder Fehlerverschleierungsverfahrens erhalten bleibt.

12. Verfahren nach einem der Ansprüche 1 bis 11, **dadurch gekennzeichnet**, daß das oder die als fehlerhaft deklarierten Bitmuster (730) der Informationseinheiten (100-700) oder die als fehlerwahrscheinlich markierten Informationsteile bei der späteren Anwendung des Fehlerkorrekturverfahrens als fehlerhaft vorausgesetzt und bei der Rekonstruktion des Ton- bzw. Zusatzinformationssignales nicht verwendet werden.

13. Verfahren nach einem der Ansprüche 1 bis 12, **dadurch gekennzeichnet**, daß das oder die als fehlerhaft deklarierten Bitmuster (730) der Informationseinheiten (100-700) oder ein oder mehrere als fehlerhaft deklarierte vollständige Informationseinheiten durch solche Bitmuster bzw. Informationseinheiten ersetzt werden, die aufgrund von Wahrscheinlichkeitsbetrachtungen als richtig oder annähernd richtig gelten.

14. Verfahren nach einem der Ansprüche 1 bis 13, bei dem die einzelnen zu übertragenden oder zu speichernden Informationsblöcke (10-80) aus Informationseinheiten (100-600) variierender Länge bestehen und eine vollständige Decodierung eines Informationsblockes (10-80) nur dann erfolgen kann, wenn alle oder ein Teil aller Informationseinheiten (100-600) sukzessive richtig decodiert werden können, **dadurch** **gekennzeichnet**, daß mit der Deklaration und ggf. Korrektur bzw. Fehlerverschleierung fehlerhafter Bitmuster (730) am Anfang eines Informationsblockes (10-80) begonnen wird.

15. Verfahren nach Anspruch 14, **dadurch gekennzeichnet**, daß nach der Deklaration eines fehlerhaften Bitmusters (730) ohne Möglichkeit zur Korrektur bzw. Fehlerverschleierung alle nachfolgenden Bitmuster als fehlerhaft deklariert werden.

16. Verfahren nach einem der Ansprüche 1 bis 15, bei dem zwei oder mehr Informationseinheiten mit einem unterschiedlichen Bitfehlerschutz versehen werden, **dadurch gekennzeichnet**, daß mit der Deklaration und ggf. Korrektur bzw. Fehlerverschleierung bei der am höchsten geschützten Informationseinheit begonnen wird.

17. Verfahren nach Anspruch 16, **dadurch gekennzeichnet**, daß nach der Deklaration eines fehlerhaften Bitmusters (730) alle Bitmuster mit geringerem Bitfehlerschutz als fehlerhaft deklariert werden.

18. Verfahren nach einem der Ansprüche 1 bis 17, **dadurch gekennzeichnet**, daß das oder die als fehlerhaft deklarierten Bitmuster (730) der Informationseinheiten oder ein oder mehrere als fehlerhaft deklarierte vollständige Informationseinheiten durch solche Bitmuster und/oder Informationseinheiten ersetzt bzw. angenähert werden, die aufgrund von Wahrscheinlichkeitsbetrachtungen solcher Bitmuster bzw. Informationseinheiten gewählt werden, welche inhaltlich vergleichbar sind und aufgrund eines höheren Schutzes oder geringeren Übertragungsstörungen als zuverlässiger gelten.

19. Verfahren nach einem der Ansprüche 5 bis 18, **dadurch gekennzeichnet**, daß die als fehlerhaft deklarierten Skalenfaktoren unter Verwendung einer Stellgröße über den Pegelverlauf bzw. die Programmdynamik und/oder eines Vektors auf einen Tabelleneintrag über den aktuellen Pegelverlauf korrigiert bzw. an die ursprünglich generierten Skalenfaktoren angenähert werden.

20. Verfahren nach einem der Ansprüche 5 bis 19, bei dem sowohl die Stellgröße über den Pegelverlauf, bzw. die Programmdynamik oder der Vektor über den Pegelverlauf als auch die Skalenfaktoren bestimmten spektralen Teilen des Tonsignals zugeordnet sind, **dadurch** **gekennzeichnet**, daß die als fehlerhaft deklarierten Skalenfaktoren unter Verwendung der Teile einer Stellgröße über den Pegelverlauf bzw. die Programmdynamik und/oder der Vektoren über den aktuellen Pegelverlauf korrigiert bzw. an diejenigen ursprünglich generierten Skalenfaktoren angenähert werden, welche denselben oder benachbarten spektralen Teilen des Tonsignals zugeordnet sind.

21. Verfahren nach einem der Ansprüche 5 bis 20, **dadurch gekennzeichnet**, daß die als fehlerhaft deklarierte Stellgröße über den Pegelverlauf bzw. die Programmdynamik oder der als fehlerhaft deklarierte Vektor auf einen Tabelleneintrag über den aktuellen Pegelverlauf unter Verwendung von Skalenfaktoren korrigiert bzw. an die ursprünglich generierte Stellgröße bzw. Vektor angenähert werden.

22. Verfahren nach einem der Ansprüche 5 bis 21, **dadurch gekennzeichnet**, daß die als fehlerhaft deklarierten Teile einer Stellgröße über den Pegelverlauf bzw. die Programmdynamik oder die als fehlerhaft deklarierten Teile der Vektoren auf einen Tabelleneintrag über den aktuellen Pegelverlauf unter Verwendung von Skalentaktoren korrigiert bzw. an die ursprünglich generierten Skalenfaktoren angenähert werden, die denselben oder benachbarten spektralen Teilen des Tonsignals zugeordnet sind.

23. Verfahren nach einem der Ansprüche 1 bis 22, **dadurch gekennzeichnet**, daß sendeseitig ein Tonsignal mit n Kanälen gleichzeitig oder verzögert mehr als einmal unter Verwendung derselben oder verschiedener Übertragungssysteme übertragen wird und empfangsseitig ein Empfänger verwendet wird, der mindestens zwei der übertragenen Tonsignale gleichen Programminhalts empfangen und verarbeiten kann, und daß die durch die Übertragung mittels eines ersten Übertragungssystems gestörten Teile des Tonsignals durch die den gestörten Teilen entsprechende oder durch angenäherte, ungestörte oder zumindestens geringer gestörte Teile des mittels eines anderen Übertragungssystems gleichzeitig oder verzögert übertragenen Tonsignals gleichen Programminhalts ersetzt werden.

24. Verfahren nach Anspruch 23, **dadurch gekennzeichnet**, daß alle Kanäle 1 bis n des mittels des einen Übertragungssystems übertragenen Tonsignals ersetzt werden durch die entsprechenden Kanäle 1 bis n des mittels eines anderen Übertragungssystems gleichzeitig oder verzögert übertrage nen Tonsignals gleichen Programminhalts.

25. Verfahren nach Anspruch 23, **dadurch gekennzeichnet**, daß nur eine Untermenge aller n Kanäle (n> = 1) des mittels des einen Übertragungssystems übertragenen Tonsignals ersetzt wird durch die entsprechende Untermenge der n Kanäle des mittels eines anderen Übertragungssystems gleichzeitig oder verzögert übertragenen Tonsignals gleichen Programminhalts.

26. Verfahren nach Anspruch 23, **dadurch gekennzeichnet**, daß die Kanäle des mittels des einen Übertragungssystems übertragenen Tonsignals ersetzt werden durch solche Kanäle des mittels eines anderen Übertragungssystems übertragenen Tonsignals, die den zu ersetzenden Kanälen entsprechen.

27. Verfahren nach Anspruch 23, **dadurch gekennzeichnet,** daß ein monophones Tonsignal ersetzt wird durch ein stereophones Tonsignal.

28. Verfahren nach einem der Ansprüche 23 bis 27, **dadurch gekennzeichnet,** daß eine zwischen den übertragenen Tonsignalen verschiedener Übertragungssysteme zeitliche Verzögerung vor Anwendung einer Fehlerverschleierung ganz oder teilweise ausgeglichen wird.

29. Verfahren nach einem der Ansprüche 23 bis 28, **dadurch gekennzeichnet** , daß eine zwischen den zur Fehlerverschleierung herangezogenen Kanälen bestehende Pegeldifferenz ganz oder teilweise ausgeglichen wird.

30. Verfahren nach einem der Ansprüche 23 bis 28, **dadurch gekennzeichnet** , daß zwischen den zur Fehlerverschleierung herangezogenen Kanälen eine Überblendung durchgeführt wird.

31. Verfahren nach einem der Ansprüche 23 bis 30, **dadurch gekennzeichnet** , daß sendeseitig eine Zusatzinformation übertragen wird, welche die Dauer der Verzögerung angibt.

32. Verfahren nach einem der Ansprüche 23 bis 31, **dadurch gekennzeichnet**, , daß sendeseitig eine Zusatzinformation übertragen wird, welche den Pegel der übertragenen Kanäle angibt.

33. Verfahren nach einem der Ansprüche 23 bis 32, **dadurch gekennzeichnet**, daß sendeseitig eine Steuerinformation für die im Falle einer gestörten Übertragung auszutauschenden Kanäle des zu bearbeitenden Tonsignals übertragen wird.

## Claims

1. Method for the error detection of a digitalized, data-reduced sound signal (7000) comprising a succession of information blocks (10-80), the individual information blocks (10-80) comprising information units (100-600), such as for example bit-allocation information (100), scale factor selecting information (200), scale factors (300,400), encoded scanning values (500) of the digitalized sound signal (1000) subjected to a sub-band filtering or a transformation in the spectral region as well as additional information (600), characterized in that one or more bit patterns (101,102,201,202,301,302, 303,401,402,403) to be allocated to the information units (100-600) of an information block (10-80) are graded as to the probability of their occurrence and, on falling below a lower probability threshold, are declared faulty.

2. Method for the error detection of a digitalized, data-reduced sound signal (7000) comprising a succession of information blocks (10-80), the individual information blocks (10-80) comprising information units (100-600), such as for example bit-allocation information (100), scale factor selecting information (200), scale factors (300,400), encoded scanning values (500) of the digitalized sound signal (1000) subjected to a sub-band filtering or a transformation in the spectral region as well as additional information (600), characterized in that two or more bit patterns (101,102,201,203,301,302, 303,401,402,403) to be allocated to the information units (100-600) of an information block (10-80) are graded as to the probability of their substantially simultaneous occurrence and, on falling below a lower probability threshold, are declared faulty.

3. Method for the error detection of a digitalized, data-reduced sound signal (7000) comprising a succession of information blocks (10-80), the individual information blocks (10-80) comprising information units (100-600), such as for example bit-allocation information (100), scale factor selecting information (200), scale factors (300,400), encoded scanning values (500) of the digitalized sound signal (1000) subjected to a sub-band filtering or a transformation in the spectral region as well as additional information (600), characterized in that one or more bit patterns (101,102,201,202,301,302, 303,401,402,403) to be allocated to the information units (100-600) of an information block (10-80) are graded as to the probability of their occurrence depending on temporally preceding and/or following bit patterns of the same or another information unit (100-600) and, on falling below a lower probability threshold, are declared faulty.

4. Method for the error detection of a digitalized, data-reduced sound signal (7000) comprising a succession of information blocks (10-80), the individual information blocks (10-80) comprising information units (100-600), such as for example bit-allocation information (100), scale factor selecting information (200), scale factors (300,400), encoded scanning values (500) of the digitalized sound signal (1000) subjected to a sub-band filtering or a transformation in the spectral region as well as additional information (600), characterized in that, with information blocks (10-80), which at the transmitting end are convolution encoded (2), converted (3) into a new information structure, split up into individual information parts, transmitted as radiofrequent signal (4000) on different spectral carrier frequencies (901-908), and at the receiving end are again joined together (4) from the individual information parts into one information structure and convolution decoded (5), those information parts, which are transmitted on individual carrier frequencies (901-908) and received with lower intensity of received field than other information parts, are marked on other carrier frequencies as regards a greater probability of error.

5. Method according to one of Claims 1 to 4, characterized in that in addition a varying control value, derived at the transmitting end from the sound signal (4000) to be transmitted and/or in addition a vector indicating a table entry relating to the level characteristic in the form of one or more additional information units (600) are inserted in the information block (10-80), and in that, at the receiving end, the control value and/or the vector is used for selecting reproduction dynamics differing from the transmitted programme dynamics.

6. Method according to Claim 5, characterized in that the control value and/or the table entry and/or the information units which include a declarative power relating to the level characteristic of the received sound signal (5000) are graded as to the probability of their substantially simultaneous occurrence and, on falling below a lower probability threshold, are declared faulty.

7. Method according to one of Claims 1 to 6, characterized in that in addition one or more codes (e.g. CRC) are generated at the encoder end for an error detection within one or more information units (100-500) and are inserted into the successive information blocks (10-80) to be transmitted or stored in the form of one or more additional information units (700), and in that at the decoder end the inserted codes (CRC) are used for an error detection (6), whereby any fixed number of errors can be detected, but the point of error cannot be precisely located.

8. Method according to Claim 7, characterized in that, following the indication of a specific number of errors by means of the additionally inserted code (CRC), the bit patterns of the information units to be examined for the error or errors are graded as to the probability of their occurrence and a number of bit patterns with the lowest probabilities as determined by the error indication is declared faulty.

9. Method according to one of Claims 1 to 8, in the case of which, at the coder end, an error protection (CRC) for the information units (100-600) or parts thereof to be transmitted or stored is also transmitted or stored along with them, and in the case of which, at the decoder end, an item of information (800) relating to the reliability of the bit patterns to be decoded is derived from the error protection, characterized by the following procedural steps:
a) A threshold (900) is determined, below which the bit patterns (710,720) to be allocated to the items of reliability information (800) are declared unreliable and
b) the bit patterns (730) to be allocated to a local minimum (830) of a sequence of items of reliability information (800) are declared faulty.

10. Method according to Claims 8 and 9, characterized in that the number of local minima (810,820) to be determined agrees with the number of errors indicated by means of the additionally inserted error-detecting code (CRC).

11. Method according to one of Claims 1 to 10, characterized in that the bit pattern or bit patterns (730) declared faulty of the information units (100-700) or the information parts marked as being probably faulty are tracked during their continued processing, and in that the knowledge relating to the inclusion of errors or the error probability is also preserved on conversion of the relevant information units (100-700) or information parts into another information structure for the subsequent application of an error-correcting or error-masking procedure.

12. Method according to one of Claims 1 to 11, characterized in that the bit pattern or bit patterns (730) declared faulty of the information units (100-700) declared faulty or the information parts marked as being probably faulty are assumed, on later application of the error-correcting procedure, to be faulty and are not used when reconstructing the sound or additional information signal.

13. Method according to one of Claims 1 to 12, characterized in that the bit pattern or bit patterns (730) declared faulty of the information units (100-700) or one or more complete information units declared faulty are replaced by such bit patterns or information units, which are to be regarded as correct or almost correct based on considerations of probability.

14. Method according to one of Claims 1 to 13, in the case of which the individual information blocks (10-80) to be transmitted or stored comprise information units (100-600) of varying length and a complete decoding of one information block (10-80) can only take place when all or a part of all information units (100-600) can be correctly decoded successively, characterized in that the declaration and possible correction or error-masking of faulty bit patterns (730) is started at the beginning of an information block (10-80).

15. Method according to Claim 14, characterized in that, following the declaration of a faulty bit pattern (730) without any possibility of correcting or error-masking, all subsequent bit patterns are declared faulty.

16. Method according to one of Claims 1 to 15, in the case of which two or more information units are provided with a different bit error protection, characterized in that the declaration and possible correction or error-masking is started with the most protected information unit.

17. Method according to Claim 16, characterized in that, following the declaration of a faulty bit pattern (730), all bit patterns with lower bit error protection are declared faulty.

18. Method according to one of Claims 1 to 17, characterized in that the bit pattern or bit patterns (730) declared faulty of the information units or one or more complete information units declared faulty are replaced or approximated with such bit patterns and/or information units, which are selected on a basis of considerations of probability of such bit patterns or information units, which have comparable content and are to be regarded as more reliable by reason of a higher protection or lower transmission interference.

19. Method according to one of Claims 5 to 18, characterized in that the scale factors declared faulty are corrected or are approximated to the scale factors originally generated, by using a control value relating to the level characteristic or the programme dynamics and/or a vector on a table entry relating to the actual level characteristic.

20. Method according to one of Claims 5 to 19, in the case of which both the control value relating to the level characteristic or the programme dynamics, or the vector relating to the level characteristic and also the scale factors are allocated to certain spectral parts of the sound signal, characterized in that the scale factors declared faulty are corrected by using the parts of a control value relating to the level characteristic, or rather the programme dynamics, and/or the vectors relating to the actual level characteristic, or are approximated to those originally generated scale factors which are allocated to the same or adjacent spectral parts of the sound signal.

21. Method according to one of Claims 5 to 20, characterized in that the control value declared faulty relating to the level characteristic or the programme dynamics, or the vector declared faulty on a table entry relating to the actual level characteristic are corrected by using scale factors, that is to say are approximated to the originally generated control value or vector.

22. Method according to one of Claims 5 to 21, characterized in that the parts declared faulty of a control value relating to the level characteristic or programme dynamics or the parts declared faulty of the vectors on a table entry relating to the actual level characteristic are corrected by using scale factors, or rather are approximated to the originally generated scale factors, which are allocated to the same or adjacent spectral parts of the sound signal.

23. Method according to one of Claims 1 to 22, characterized in that, at the transmitting end, a sound signal is transmitted with n channels simultaneously or with a time-delay more than once by using the same or different transmission systems and, at the receiving end, a receiver is used which can receive and process at least two of the transmitted sound signals having identical programme content, and in that the parts of the sound signal disturbed due to transmission by means of a first transmission system are replaced with undisturbed or at least less disturbed parts of the sound signal having identical programme content which correspond to or approximate the disturbed parts and are transmitted simultaneously or with a time-delay by means of another transmission system.

24. Method according to Claim 23, characterized in that all channels 1 to n of the sound signal transmitted by means of one transmission system are replaced by the corresponding channels 1 to n of the sound signal with identical programme content transmitted simultaneously or with a time-delay by means of another transmission system.

25. Method according to Claim 23, characterized in that only one subset of all n channels (n > = 1) of the sound signal transmitted by means of one transmission system is replaced by the corresponding subset of the n channels of the sound signal with the same programme content transmitted simultaneously or with a time-delay by means of another transmission system.

26. Method according to Claim 23, characterized in that the channels of the sound signal transmitted by means of one transmission system are replaced by such channels of the sound signal transmitted by means of another transmission system which correspond to the channels to be replaced.

27. Method according to Claim 23, characterized in that a monophonic sound signal is replaced by a stereophonic sound signal.

28. Method according to one of Claims 23 to 27, characterized in that a time-delay between the transmitted sound signals of different transmission systems is completely or partly compensated prior to application of an error masking.

29. Method according to one of Claims 23 to 28, characterized in that a level difference existing between the channels consulted for the error masking is completely or partly compensated.

30. Method according to one of Claims 23 to 28, characterized in that a fade-over is effected between the channels consulted for the error masking.

31. Method according to one of Claims 23 to 30, characterized in that, at the transmitting end, an additional item of information is transmitted which indicates the duration of the delay.

32. Method according to one of Claims 23 to 31, characterized in that, at the transmitting end, an additional item of information is transmitted which indicates the level of the transmitted channels.

33. Method according to one of Claims 23 to 32, characterized in that, at the transmitting end, an item of control information is transmitted for the channels of the sound signal to be processed which are to be replaced in the event of a disturbed transmission.

## Revendications

1. Procédé de détection d'erreurs d'un signal audio (7000) numérisé, à données comprimées, constitué d'une séquence de blocs d'information (10 à 80), les blocs d'informations individuels (10 à 80) se composant d'unités d'informations (100 à 600), tels par exemple, qu'une information d'assignation (100) de bits, une information de sélection (200) de facteur d'échelle, des facteurs d'échelle (300, 400), des valeurs de détection encodées du signal audio (1000) numérisé, soumis à un filtrage de bande partielle ou à une transformation dans le domaine spectral ainsi qu'une information additionnelle (600), caractérisé en ce que une ou plusieurs configurations de bits (101, 102, 201, 202, 301, 302, 303, 401, 402, 403) à associer aux unités d'information (100 à 600) d'un bloc d'information (10 à 80) sont classées en ce qui concerne la vraisemblance de leur apparition et sont déclarées erronées lorsqu'un seuil inférieur de vraisemblance n'est pas atteint.

2. Procédé de détection d'erreurs d'un signal audio (7000) numérisé, à données comprimées, constitué d'une séquence de blocs d'information (10 à 80), les blocs d'informations individuels (10 à 80) se composant d'unités d'informations (100 à 600), tels par exemple, qu'une information d'assignation (100) de bits, une information de sélection (200) de facteur d'échelle, des facteurs d'échelle (300, 400), des valeurs de détection encodées du signal audio (1000) numérisé, soumis à un filtrage de bande partielle ou à une transformation dans le domaine spectral ainsi qu'une information additionnelle (600), caractérisé en ce que deux ou plusieurs configurations de bits (101, 102, 201, 202, 301, 302, 303, 401, 402, 403) à associer aux unités d'information (100 à 600) d'un bloc d'information (10 à 80) sont classées en ce qui concerne la vraisemblance de leur apparition sensiblement simultanée et sont déclarées erronées lorsqu'un seuil inférieur de vraisemblance n'est pas atteint.

3. Procédé de détection d'erreurs d'un signal audio (7000) numérisé, à données comprimées, constitué d'une séquence de blocs d'information (10 à 80), les blocs d'informations individuels (10 à 80) se composant d'unités d'informations (100 à 600), tels par exemple, qu'une information d'assignation (100) de bits, une information de sélection (200) de facteur d'échelle, des facteurs d'échelle (300, 400), des valeurs de détection encodées du signal audio (1000) numérisé, soumis à un filtrage de bande partielle ou à une transformation dans le domaine spectral ainsi qu'une information additionnelle (600), caractérisé en ce que une ou plusieurs configurations de bits (101, 102, 201, 202, 301, 302, 303, 401, 402, 403) à associer aux unités d'information (100 à 600) d'un bloc d'information (10 à 80) sont classées en ce qui concerne la vraisemblance de leur apparition en fonction de configurations de bits qui les précèdent dans le temps et/ou qui les suivent dans le temps ou d'une autre unité d'information (100, 600) et sont déclarées erronées lorsqu'un seuil inférieur de vraisemblance n'est pas atteint.

4. Procédé de détection d'erreurs d'un signal audio (7000) numérisé, à données comprimées, constitué d'une séquence de blocs d'information (10 à 80), les blocs d'informations individuels (10 à 80) se composant d'unités d'informations (100 à 600), tels par exemple, qu'une information d'assignation (100) de bits, une information de sélection (200) de facteur d'échelle, des facteurs d'échelle (300, 400), des valeurs de détection encodées du signal audio (1000) numérisé, soumis à un filtrage de bande partielle ou à une transformation dans le domaine spectral ainsi qu'une information additionnelle (600), caractérisé en ce que, dans le cas de blocs d'information (10 à 80) qui sont encodés par pliage (2) sur le côté émetteur, convertis (3) en une nouvelle structure d'information, divisés en parties individuelles d'information, transmises sous la forme d'un signal de radiofréquence (4000) sur des fréquences porteuses spectrales différentes (901 à 908) et sont de nouveau assemblés (4) sur le côté réception en une structure d'information à partir des parties d'information individuelles et décodées (5) par pliage, les parties d'information qui sont transmises sur des fréquences porteuses individuelles (901 à 908) et qui sont reçues avec une intensité de champ de réception plus faible que d'autres parties d'information, sont marquées d'une vraisemblance d'erreur plus élevée que celle d'autres fréquences porteuses.

5. Procédé selon l'une des revendications 1 à 4, caractérisé en ce que, de plus, une variable réglante, qui varie et est dérivée sur le côté émetteur à partir du signal audio à transférer (4000) et/ou, de plus, un vecteur indicatif d'une inscription dans une table concernant l'allure du niveau est introduit sous la forme d'une ou plusieurs unités d'information additionnelles (600) dans le bloc d'information (10 à 80) et en ce que la variable réglante et/ou le vecteur sont utilisés sur le côté réception pour sélectionner une dynamique de reproduction qui s'écarte de la dynamique de programme transmise.

6. Procédé selon la revendication 5, caractérisé en ce que la variable réglante et/ou l'inscription dans une table et/ou les unités d'information qui contiennent une force d'information concernant l'allure de niveau du signal audio reçu (5000) sont classés en ce qui concerne la vraisemblance de leur apparition sensiblement simultanée et sont déclarés erronés lorsqu'un seuil inférieur de vraisemblance n'est pas atteint.

7. Procédé selon l'une des revendications 1 à 6, caractérisé en ce que, de plus, un ou plusieurs codes (par exemple CRC) sont engendrés pour une détection d'erreurs à l'intérieur d'une ou plusieurs unités d'information (100 à 500) et sont introduits sous forme d'une ou plusieurs unités additionnelles d'information (700) dans les blocs d'information successifs (10 à 80) à transmettre ou à mémoriser (10 à 80) et en ce que les codes introduits (CRC) sont utilisés pour une détection d'erreurs (6) sur le côté du décodeur, un nombre sélectionné à volonté mais fixe d'erreurs pouvant être détecté, mais l'emplacement de l'erreur ne pouvant cependant pas être localisé avec précision.

8. Procédé selon la revendication 7, caractérisé en ce que les configurations de bits des unités d'information à prendre en considération pour l'erreur ou pour les erreurs sont classées en ce qui concerne la vraisemblance de leur apparition en fonction de l'indication d'un nombre défini d'erreurs par le code introduit de façon individuelle (CRC) et en ce qu'un nombre de configurations d'erreurs, défini par l'indication d'erreurs, dont les vraisemblances sont les plus faibles sont déclarés erronées.

9. Procédé selon l'une des revendications 1 à 8, dans lequel un contrôle d'erreurs (CRC) pour les unités d'information (100 à 600) à transmettre ou à mémoriser ou pour des parties de celles-ci est inclus transmis ou mémorisé avec celles-ci du côté encodeur et dans lequel une information (800) concernant la fiabilité des configurations de bits à décoder est dérivés du côté décodeur à partir du contrôle d'erreurs, caractérisé par les étapes de procédé suivantes:
a) il est défini un seuil (900) au dessous duquel les configurations de bits (710 à 720) à associer aux informations de fiabilité (800) sont déclarées non fiables, et
b) les configurations de bits (830) qui sont à associer à un minimum local (730) d'une séquence d'informations de fiabilité (800) sont déclarées erronées.

10. Procédé selon les revendications 8 et 9 caractérisé en ce que le nombre des minima locaux à définir (810, 820) coïncide avec le nombre d'erreurs indiqué par le code de détection d'erreurs (CRC) introduit de façon additionnelle.

11. Procédé selon l'une des revendications 1 à 10, caractérisé en ce que la ou les configurations de bits (730) d'unités d'information (100 à 700) qui sont déclarées erronées ou les parties d'information qui sont marquées comme vraisemblablement erronées passent par un autre trajet de traitement et en ce que la connaissance qui concerne le caractère erroné ou la vraisemblance d'erreur est maintenue en vue d'être utilisées ultérieurement dans un procédé de correction d'erreurs ou de masquage d'erreurs, même lorsque des unités d'information correspondantes (100 à 700) ou des parties d'information sont transformées dans une autre structure d'information.

12. Procédé selon l'une des revendications 1 à 11, caractérisé en ce que la ou les configurations de bits (730) des unités d'information (100 à 700) qui sont déclarées erronées ou les parties d'information qui sont marqués comme vraisemblablement erronées, sont supposées erronées lors de l'utilisation ultérieure du procédé de correction d'erreurs et ne sont pas employées lors de la reconstruction du signal audio ou du signal d'information additionnelle.

13. Procédé selon l'une des revendications 1 à 12, caractérisé en ce que la où les configurations de bits (730) déclarées erronées des unités d'information (100 à 700) ou une ou plusieurs unités d'information complètes déclarées erronées sont remplacées par des configurations de bits ou des unités d'information qui sont considérées comme correctes ou approximativement correctes en raison de considérations de vraisemblance.

14. Procédé selon l'une des revendications 1 à 13 dans lequel les blocs d'informations individuels (10 à 80) à transmettre ou à mémoriser se composent d'unités d'information (100 à 600) de longueur variable et un décodage complet d'un bloc d'information (10 à 80) ne peut se produire que lorsque la totalité ou une partie des unités d'information (100 à 600) peut être décodée successivement de façon correcte, caractérisé en ce que le début d'un bloc d'information (10 à 80) commence par la déclaration et éventuellement la correction ou le masquage d'erreurs de configurations de bits erronées (730).

15. Procédé selon la revendication 14 caractérisé en ce que toutes les configurations de bits qui suivent la déclaration d'une configuration de bits (730) erronée sans possibilité de correction ou de masquage d'erreurs sont déclarées erronées.

16. Procédé selon l'une des revendications 1 à 15, dans lequel deux ou plusieurs unités d'information sont pourvues d'un contrôle d'erreurs de bits différent, caractérisé en ce que le processus de déclaration et éventuellement de correction ou de masquage d'erreurs commence par l'unité d'information à contrôle d'erreurs le plus élevé.

17. Procédé selon la revendication 16, caractérisé en ce que toutes les configurations de bits qui suivent une déclaration d'une configuration de bits erronée (730) et dont le contrôle d'erreurs de bits est plus faible sont déclarées erronées.

18. Procédé selon l'une des revendications 1 à 17, caractérisé en ce que la configuration ou les configurations de bits déclarées erronées (730) des unités d'information, ou une ou plusieurs unités d'information complètes déclarées erronées sont remplacées ou approchées par des configurations de bits et/ou des unités d'information qui sont sélectionnées sur la base de considérations de vraisemblance comme des configurations de bits ou des unités d'information qui sont comparables en ce qui concerne leur contenu et qui sont considérées comme plus fiable en raison d'un contrôle plus élevé ou de perturbations plus faibles de transmission.

19. Procédé selon l'une des revendications 15 à 18, caractérisé en ce que les facteurs d'échelle déclarés erronés sont corrigés, ou sont rapprochés des facteurs d'échelle engendrés à l'origine, en utilisant une variable réglante qui concerne l'allure de niveau ou la dynamique de programme et/ou en utilisant un vecteur d'une inscription dans une table concernant l'allure actuel de niveau.

20. Procédé selon l'une des revendications 5 à 19, dans lequel tant la variable réglante concernant l'allure du niveau ou la dynamique de programme ou le vecteur concernant l'allure de niveau que les facteurs d'échelles sont associés à des parties spectrales définies du signal audio, caractérisé en ce que les facteurs d'échelles déclarés erronés sont corrigés, ou sont rapprochés des facteurs d'échelles engendrés à l'origine qui sont associés aux mêmes parties spectrales ou à des parties spectrales voisines du signal audio, en utilisant les parties d'une variable réglante concernant l'allure de niveau ou la dynamique de programme et/ou les vecteurs concernant l'allure actuel de niveau.

21. Procédé selon l'une des revendications 5 à 20, caractérisé en ce que la variable réglante concernant l'allure de niveau ou la dynamique de programme déclarée erronée ou le vecteur déclaré erroné d'une inscription dans une table concernant l'allure actuelle de niveau est corrigé ou rapproché de la variable réglante ou du vecteur engendrés à l'origine en utilisant les facteurs d'échelles.

22. Procédé selon l'une des revendications 5 à 21, caractérisé en ce que les parties déclarées erronées d'une variable réglante concernant l'allure de niveau ou la dynamique de programme ou les parties déclarées erronées des vecteurs d'une inscription dans une table concernant l'allure actuelle de niveau sont corrigés en utilisant des facteurs d'échelles, ou rapprochés des facteurs d'échelles engendrés à l'origine, qui sont associés aux mêmes parties spectrales ou à des parties spectrales voisines du signal audio.

23. Procédé selon l'une des revendications 1 à 22, caractérisé en ce qu'un signal audio est transmis plus d'une fois côté émetteur par N canaux, simultanément ou en étant retardé, en utilisant les mêmes systèmes ou des systèmes différents de transmission et qu'il est utilisé sur le côté réception un récepteur qui peut recevoir et traiter au moins deux des signaux audio transmis à même contenu de programme et en ce que les parties du signal audio perturbées par la transmission par un premier système de transmission sont remplacés par les parties correspondantes aux parties perturbées ou par des parties approchées, non perturbées ou au moins perturbées dans une moindre mesure du signal audio à même contenu de programme, transmis simultanément ou de façon retardée par un autre système de transmission.

24. Procédé selon la revendication 23, caractérisé en ce que tous les canaux de 1 à n du signal audio transmis par le premier système de transmission sont remplacés par les canaux correspondants 1 à n du signal audio à même contenu de programme transmis simultanément ou de façon retardée par un autre système de transmission.

25. Procédé selon la revendication 23 caractérisé en ce que seul un sous-ensemble de tous les n canaux (n ≥ 1) du signal audio transmis par le système de transmission est remplacé par le sous-ensemble correspondant des n canaux du signal audio à même contenu de programme transmis simultanément ou de façon retardée par un autre système de transmission.

26. Procédé selon la revendication 22, caractérisé en ce que les canaux du signal audio transmis par le premier système de transmission sont remplacés par des canaux du signal audio transmis par un autre système de transmission qui correspondent aux canaux à remplacer.

27. Procédé selon la revendication 23, caractérisé en ce qu'un signal audio monotone est remplacé par un signal audio stéréophone.

28. Procédé selon l'une des revendications 23 à 27, caractérisé en ce qu'un retard temporel entre les signaux audio transmis par différents systèmes de transmission est totalement ou partiellement compensé avant l'utilisation d'un masquage d'erreurs.

29. Procédé selon l'une des revendications 23 à 28, caractérisé en ce qu'une différence de niveau qui subsiste entre les canaux retirés pour le masquage d'erreurs est totalement ou partiellement compensé.

30. Procédé selon l'une des revendications 23 à 28, caractérisé en ce que un mélange est exécuté entre les canaux retirés pour le masquage d'erreurs.

31. Procédé selon l'une des revendications 23 à 30, caractérisé en ce qu'une information additionnelle, qui indique la durée de retard, est transmise du côté émetteur.

32. Procédé selon l'une des revendications 23 à 31, caractérisé en ce qu'une information additionnelle, qui indique le niveau des canaux transmis, est transmise du côté émetteur.

33. Procédé selon l'une des revendications 23 à 32, caractérisé en ce qu'une information de commande, concernant les canaux du signal à traiter qui sont à échanger dans le cas d'une transmission perturbée, est transmise du côté émetteur.
